Europäisches Patentamt

**European Patent Office**

**Office européen des brevets**

(19)

(11) Veröffentlichungsnummer: **0 118 797**
**B1**

(12) **EUROPÄISCHE PATENTSCHRIFT**

(45) Veröffentlichungstag der Patentschrifft:
28.02.90

(21) Anmeldenummer: **84101637.1**

(22) Anmeldetag: **17.02.84**

(51) Int. Cl. ⁵: **H 01 L 31/06**

(54) Solarzelle.

(30) Priorität: **09.03.83 DE 3308269**

(43) Veröffentlichungstag der Anmeldung:
**19.09.84 Patentblatt 84/38**

(45) Bekanntmachung des Hinweises auf die Patenterteilung:
**28.02.90 Patentblatt 90/09**

(84) Bennante Vertragsstaaten:
**FR GB NL**

(56) Entgegenhaltungen:
**EP-A-0 058 543**
**DE-A-1 614 832**
**FR-A-2 218 657**
**FR-A-2 286 509**
**FR-A-2 382 772**
**FR-A-2 394 895**
**GB-A-2 062 351**
**US-A-4 153 476**
**US-A-4 163 677**
**US-A-4 169 738**
**US-A-4 260 428**
**US-A-4 343 830**
**US-A-4 361 717**

(73) Patentinhaber: **Licentia Patent-Verwaltungs-GmbH**
**Theodor-Stern-Kai 1**
**D-6000 Frankfurt/Main 70 (DE)**
Patentinhaber: **TELEFUNKEN electronic GmbH**
**Theresienstrasse 2**
**D-7100 Heilbronn (DE)**

(72) Erfinder: **Gochermann, Hans, Dipl.-Ing.**
**Schmidt-Isserstedt-Weg 2**
**D-2081 Holm (DE)**
Erfinder: **Rasch, Klaus-Dieter, Dr. Dipl.-Phys.**
**Hundsbergstrasse 10/1**
**D-7129 Talheim (DE)**
Erfinder: **Schmidt, Wilfried, Dipl.-Phys.**
**Schillerstrasse 11**
**D-7129 Talheim (DE)**
Erfinder: **Tentscher, Karl-Heinz**
**Sontheimer Landwehr 56**
**D-7100 Heilbronn (DE)**

(74) Vertreter: **Maute, Hans-Jürgen, Dipl.-Ing.**
**Licentia Patent-Verwaltungs-GmbH Theodor-Stern-Kai 1**
**D-6000 Frankfurt/Main 70 (DE)**

EP 0 118 797 B1

## Beschreibung

Die Erfindung betrifft eine Solarzelle aus einem scheibenförmigen Halbleiterkörper, der einen pn-Übergang enthält, wobei die beiden den pn-Übergang bildenden Zonen der Solarzelle auf gegenüberliegenden Oberflächenseiten des Halbleiterkörpers mit einem strukturierten, wesentliche Bereiche der Halbleiteroberfläche unbedeckt lassenden Leitbahnsystem kontaktiert sind.

Solarzellen, die für eine beiderseitige Bestrahlung geeignet sind, sind beispielsweise aus der DE-OS-1 614 832 bekannt. Die bekannte Solarzelle weist an beiden Oberflächenseiten des Halbleiterkörpers mehrere pn-Übergänge auf. Diese Solarzelle muß daher mehreren Diffusionsprozessen unterworfen werden und ist somit aufwendig und teuer in der Herstellung.

Ferner sind einseitig bestrahlbare Solarzellen bekannt, die auf der für die Lichteinstrahlung vorgesehen Oberflächenseite mit einem gitter- oder fingerförmigen Leitbahnsystem versehen sind. Die Rückseite des Halbleiterkörpers wird mit einem die gesamte Fläche bedeckenden Kontakt versehen. Diese einseitig bestrahlbare Solarzelle hat den Nachteil, daß die Rückseite nicht für den Lichteinfall genutzt werden kann, und es in der Solarzelle zu einer durch die einfallende Wärmestrahlung bedingten Erhöhung der Betriebstemperatur kommt, wodurch der Wirkungsgrad der Solarzelle reduziert wird. Dies beruht darauf, daß der großflächige Rückseitenkontakt den Wiederaustritt der einfallenden Wärmestrahlung aus der Zellenrückseite verhindert. Verbesserungen durch eine besondere Oberflächenbehandlung der Zellenrückseite sind kostspielig.

Aus der FR-A-2 218 657 ist eine Solarzelle bekannt, bei der der Rückseitenkontakt mit einer Gitterstruktur versehen ist, um die Wärmebelastung der Solarzelle zu reduzieren.

Der vorliegenden Erfindung liegt daher die Aufgabe zugrunde, eine Solarzelle anzugeben, die einen höheren Wirkungsgrad besitzt als einseitig bestrahlbare Solarzellen und zugleich mit geringem technologischem Aufwand kostengünstig hergestellt werden kann. Hierbei wird angestrebt, daß diese Solarzelle in Generatoren aller Art unter Zuhilfenahme bekannter Technologien eingebaut werden kann. Diese Aufgabe wird bei einer Solarzelle der eingangs genannten Art erfindungsgemäß dadurch gelöst, daß der Halbleiterkörper vom ersten Leitungstyp eine gleichmäßige Dotierung aufweist, daß an einer Oberflächenseite des Halbleiterkörpers eine dünne, gegenüber dem Grundkörper höher dotierte Zone vom zweiten Leitungstyp vorgesehen ist, daß beide Oberflächenseiten des Halbleiterkörpers für die Bestrahlung vorgesehen sind und daß zu Reduzierung des Serienwiderstandes des Kontaktes an der schwächer dotierten Zone der Abstand zwischen benachbarten Strukturen des Kontaktes geringer ist als beim Kontakt an der höher dotierten Zone.

Die erfindungsgemäße Solarzelle weist somit nur einen einzigen pn-Übergang auf und muß daher nur einem Dotierungsschritt unterworfen werden. Da auf beiden Oberflächenseiten der Solarzelle nur kleine Oberflächenanteile mit den strukturierten Leitbahnsystem versehen sind, ist die für den Lichteinfall auf Vorder- und Rückseite zur Verfügung stehende Oberfläche der Solarzelle groß, so daß ein hoher Gesamtwirkungsgrad erzielt wird. Außerdem kann die Wärmestrahlung bei der erfindungsgemäßen Solarzelle nahezu ungehindert durch die Zelle hindurchtreten, so daß die Zelle niedrige Betriebstemperaturen aufweist und keine thermomechanischen Probleme auftreten.

Bei der erfindungsgemäßen Solarzelle ist die Oberflächenseite des Halbleiterkörpers, in die die Zone vom zweiten Leitungstyp eingelassen ist, vorzugsweise für die Lichteinstrahlung aus der Haupteinfallsrichtung mit der höheren Intensität vorgesehen, während die etwas unempfindlichere, gegenüberliegende Rückseite des Halbleiterkörpers für den Eintritt des Lichtes aus der Einfallsrichtung mit geringerer Intensität gedacht ist. Daraus ergibt sich, daß das auf die Rückseite der Solarzellen fallende Licht ausgenutzt werden kann, ohne daß Mehrkosten für die Zellen oder Generatorherstellung entstehen. Bei einer Anwendung der erfindungsgemäßen Solarzelle innerhalb von orbitalen Solargeneratoren kann folglich die Streustrahlung der Erde ausgenutzt werden. Bei terrestrischen Solargeneratoren werden die Solarzellen mit ihrer Vorderseite beispielsweise zur Sonne ausgerichtet bzw. dieser nachgeführt. Auch hier kann wiederum die stets vorhandene Streustrahlung zur Einstrahlung in die Rückseite der Solarzelle ausgenutzt werden. Die Streustrahlung ergibt sich beispielsweise in besonders hoher Intensität bei gut reflektierenden Umgebungen des Generators, beispielsweise bei einer schneebedeckten Umgebung oder beim Einsatz der Generatoren über Sandboden in Wüstengebieten.

Die Solarzelle nach der Erfindung kann aus einkristallinem oder auch aus multikristallinem Silizium bestehen. Allerdings muß bei einer Verwendung von multikristallinem Silizium die Solarzelle einem Passivierungsprozeß unterworfen werden, durch den die effektive Diffusionslänge der Minoritätsladungsträger und damit die Lichtempfindlichkeit der Solarzelle erhöht wird. Zur Passivierung eignet sich insbesondere Wasserstoff. Der Passivierungsprozeß wird beispielsweise in einem Wasserstoffplasma durchgeführt.

Die Dotierung des Halbleitergrundkörpers vom ersten Leitungstyp wird bei der erfindungsgemäßen Solarzelle derart hoch gewählt, daß bei entsprechend kleinen Abständen zwischen benachbarten Strukturen des rückseitigen Leitbahnsystems der hierdurch bedingte Anteil des Serienwiderstandes der Zelle klein wird gegenüber dem Gesamtserienwiderstand. Ferner soll der Halbleitergrundkörper so dünn gewählt werden, daß ein wesentlicher Anteil der rückseitig durch Lichteinstrahlung erzeugten Minoritätsladungsträger zum pn-Übergang gelangt. Durch diese speziellen Maßnahmen wird sichergestellt, daß ein hoher Anteil der durch Lichteinfall erzeugten Minoritätsladungsträger für die Stromgewinnung nutzbar gemacht wird. Der Serienwiderstand der Solarzelle wird vorzugsweise dadurch weiter reduziert, daß zumindest der Teilbereich der Rückseite des Halbleiterkörpers zwischen den Strukturen des Leitbahnsystems mit einer transparenten und gut leitfähigen Schicht bedeckt ist. Diese Schicht kann zugleich als Antireflexschicht wirksam sein. Zugleich schützt die Antireflexschicht die von ihr bedeckten Teile der Oberfläche des Halbleiterkörpers und, falls sie sich auch über die Leitbahnsysteme erstreckt, werden durch sie auch diese Kontaktstrukturen vor äußeren Einflüssen geschützt.

Bei der erfindungsgemäßen Solarzelle kann sich folglich auf einer oder auf beiden Oberflächenseiten der Solarzelle eine Antireflexschicht befinden. Bei Antireflexschichten auf der Vorder- und Rückseite der Solarzelle werden diese dann den in diese Flächen einfallenden Lichtverhältnissen bezüglich der spektralen Verteilung angepaßt.

Zur Reduzierung des Serienwiderstandes der Solarzelle sind erfindungsgemäß die Abstände zwischen den Strukturen des Leitbahnsystem beim Vorderseitenkontakt größer als die beim Rückseitenkontakt. Die erfindungsgemäße Solarzelle ist extrem einfach aufgebaut, da in den gleichmäßig dotierten Grundkörper nur eine Sperrschicht beispielsweise durch Diffusion eingebracht wird. Die Zelle ist damit extrem kostengünstig herstellbar und hat einen sehr hohen Wirkungsgrad durch den beiderseitigen Lichteinfall. Durch die Ausgestaltung der Leitbahnsysteme auf der Vorder- und Rückseite der Solarzelle wird eine weitere Verbesserung des Wirkungsgrades bewirkt, da die Betriebstemperatur der Zelle infolge der leicht durch die Zelle hindurchtretenden Wärmestrahlung relativ niedrig ist. Bereits eine um 10 °C geringere Betriebstemperatur bewirkt eine um 5 % höhere Zellenleistung. Die strukturierten Leitbahnsysteme haben ferner gegenüber großflächigen Kontakten den Vorteil einer erhöhten Temperaturwechselfestigkeit. Ferner führen die strukturierten Leitbahnsysteme mit sehr feinen Gitter- oder Fingerstrukturen zu erheblichen Materialkosteneinsparungen, da das Kontaktmaterial, das vielfach aus Edelmetallen besteht, sehr teuer ist.

Weitere vorteilhafte Ausgestaltungen der erfindungsgemäßen Solarzelle und ihr vorteilhafter Einsatz in orbitalen oder terrestrischen Solarzellengeneratoren ergeben sich aus den Unteransprüchen.

Die Erfindung und ihre weitere vorteilhafte Ausgestaltung wird nachstehend noch anhand von Ausführungsbeispielen näher erläutert.

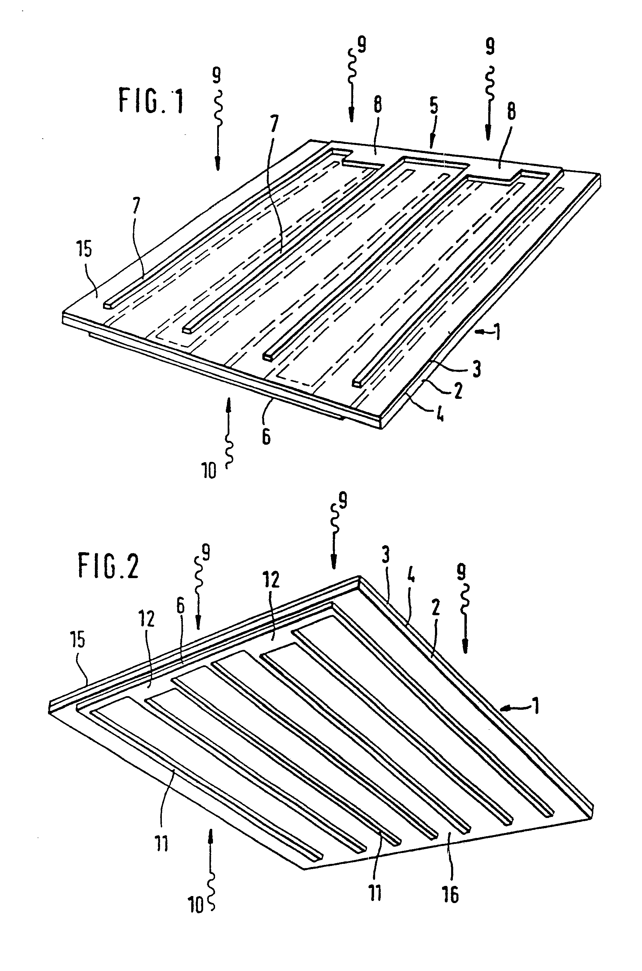

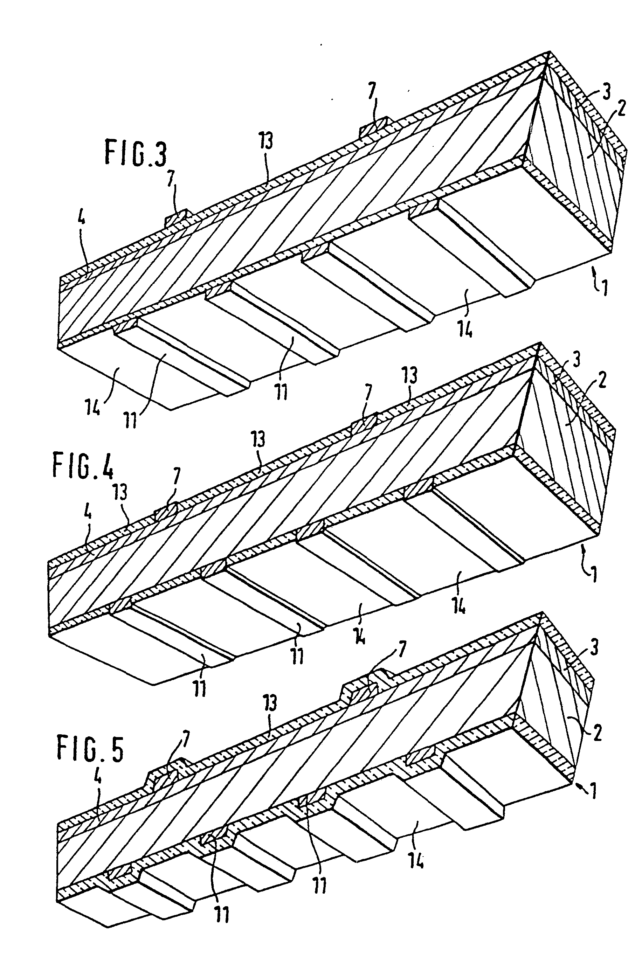

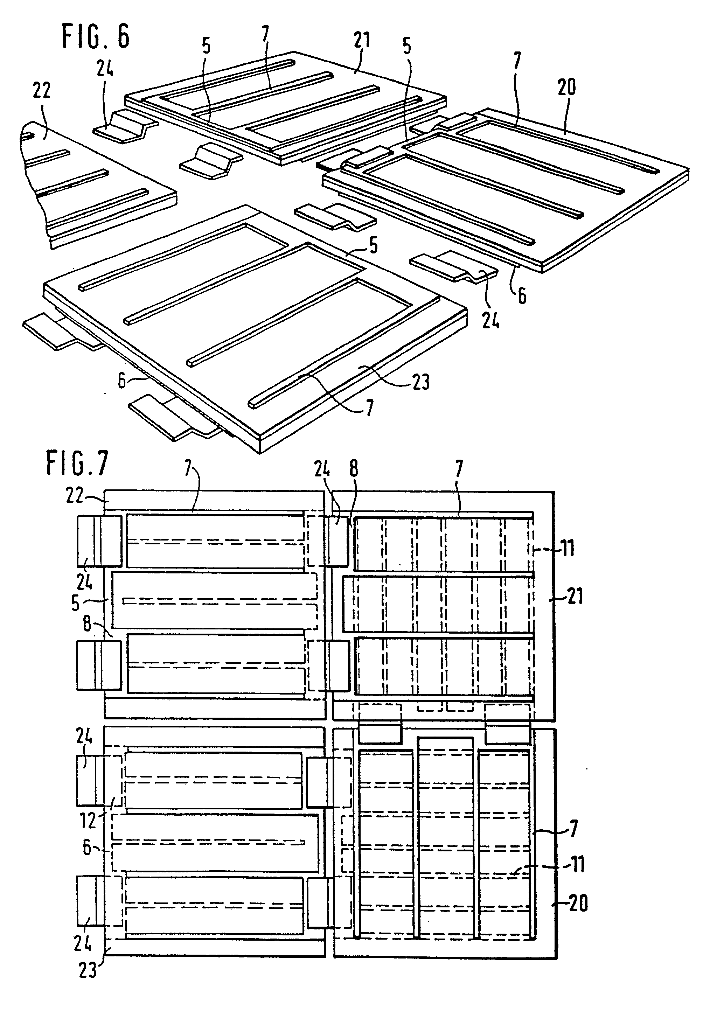

Die Figur 1 zeigt die Vorderseite der Solarzelle während die Figur 2 die Rückseite der Solarzelle darstellt. Die Figuren 3 bis 5 zeigen verschiedene Möglichkeiten für die Anordnung einer gut leitfähigen, transparenten Schicht auf den Halbleiteroberflächen der Solarzelle. Die Figur 6 zeigt, in welcher Weise verschiedene Solarzellen zu einem Teil eines Generators miteinander verschaltet werden können.

Aus der Figur 7 ergibt sich, wie bei einer derartigen Verschaltung die Leitbahnsysteme auf den beiden Oberflächenseiten der Solarzellen anzuordnen sind. In Figur 8 ist ein Ausschnitt aus einem Verbundglasgenerator für terrestrische Anwendungszwecke dargestellt. Figur 9 zeigt einen Ausschnitt eines Generators, bei dem der Träger aus glasfaserverstärktem Harz besteht. In Figur 9 ist ein Ausschnitt eines orbitalen Solargenerators dargestellt.

In der Figur 1 ist in einer perspektivischen Darstellung eine Ausführungsform der erfindungsgemäßen Solarzelle mit Blick auf deren Vorderseite dargestellt. Die Solarzelle 1 besteht aus einer dünnen, rechteckförmigen oder runden Scheibe aus einem geeigneten Halbleitermaterial. Vorzugsweise handelt es sich bei dem Halbleitermaterial um einkristallines Silizium oder um multikristallines Silizium. Bei einem multikristallinen Silizium muß die Halbleiterscheibe einem Passivierungsprozeß unterzogen werden, durch den die effektive Diffusionslänge der Minoritätsladungsträger erhöht wird. Hierzu ist beispielsweise eine Glimmentladung in einem HF-Wasserstoffplasma geeignet. Die Passivierung kann während einer Zeit von einer Stunde bei 300°C durchgeführt werden. Durch diesen Vorgang werden Rekombinationszentren der Halbleiterscheibe passiviert.

Bei einer Solarzelle aus einkristallinem Silizium ist die Dicke der Scheibe 1 vorzugsweise kleiner als 0,3 mm. Der einheitlich dotierte Halbleitergrundkörper 2 hat einen relativ geringen spezifischen Widerstand von ca. 0,1 bis 1 Ohmcm, während die in diesen Grundkörper von der Vorderseite aus eingebrachte Oberflächenzone 3 vom zum Grundkörper entgegengesetztem Leitungstyp sehr niederohmig ist und einen Schichtwiderstand von ca. 30 bis 200 Ohm/square besitzt. Diese dünne Oberflächenzone 3 ist beispielsweise 0,5 µm dick. Der pn-Übergang 4 kann durch Diffusion oder Implantation von geeigneten Störstellen hergestellt werden. Durch die Dotierung kommt somit eine $p^+n$- bzw. $n^+p$-Struktur der Solarzelle 1 zustande.

Auf die Vorderseite 15 der Solarzelle, die für die Lichteinstrahlung aus der Haupteinfallsrichtung 9 mit der höheren Lichtintensität vorgesehen ist, wird zur ohmschen Kontaktierung der Oberflächenzone 3 ein strukturiertes Leitbahnsystem 5 aufgebracht. Dieses Leitbahnsystem weist beispielsweise die dargestellte Fingerstruktur auf, wobei die parallel zueinander verlaufenden Einzelfinger 7 in eine am Rand der Solarzelle angeordnete Sammelschiene münden, die verbreiterte Anschlußstellen 8 für die Verbindungselemente zu weiteren Solarzellen aufweist.

Das Leitbahnsystem 5 besteht beispielsweise aus aufgedampftem oder aufgesputtertem Aluminium oder aus einer Titan-Palladium-Silber-Schichtenfolge. Die Silberschicht kann ebenso wie das zuvor erwähnte Aluminium auch durch Siebdruck hergestellt werden. Ferner kann ein Leitbahnsystem aus stromlos platiertem Nickel bestehen. Die einzelnen Finger 7 des Leitbahnsystems haben beispielsweise eine Breite von 200 µm und weisen von dem benachbarten Finger einen Abstand von 1 bis 1,5 mm auf. Die Dicke des Leitbahnsystems liegt zwischen 2 bis 10 µm.

Aus der Figur 2 ergibt sich das Aussehen der Zellenrückseite 16, die für den Lichteinfall etwas unempfindlicher ist als die Vorderseite 15 und für den Eintritt des Lichtes aus der Einfallsrichtung 10 mit geringer Lichtintensität vorgesehen ist. Auf der Rückseite 16 ist gleichfalls ein Leitbahnsystem 6 angeordnet, das im dargestellten Ausführungsbeispiel wiederum aus parallel zueinander verlaufenden Einzelfingern 11 besteht, die in eine am Rand der Zelle angeordnete Sammelschiene münden und dort verbreiterte Anschlußstellen 12 für die Verbinder zwischen benachbarten Solarzellen aufweisen. Der Abstand zwischen den Fingerstrukturen 11 ist geringer als der zwischen den Fingern 7 auf der Vorderseite 15 der Solarzelle. Hierdurch wird in Verbindung mit der Dotierung des Halbleitergrundkörpers 2 der durch Grundkörper und Leitbahnsystem bedingte Anteil des Serienwiderstandes der Zelle klein gegenüber dem Gesamtserienwiderstand. Der Abstand zwischen den Fingerstrukturen 11 auf der Zellenrückseite 16 beträgt im geschilderten Ausführungsbeispiel ca. 0,5 mm während die Breite der einzelnen Finger 11 ca. 100 µm beträgt. Auch hier ist das Leitbahnsystem ca. 2 bis 10 µm dick und besteht aus den bereits genannten Materialien.

Bei der dargestellten Solarzelle, deren Dicke vorzugsweise unter 300 µm liegt und deren Grundkörper 2 eine relativ hohe Dotierung aufweist, ist sichergestellt, daß ein wesentlicher Anteil der rückseitig durch Lichteinstrahlung erzeugten Minoritätsladungsträger zum pn-Übergang 4 gelangen, so daß beispielsweise das von der Solarzellenrückseite aufgefangene Streulicht erheblich zur vergrößerten Leistungsausbeute der Zelle beiträgt.

In der Figur 3 ist nur ein Teil einer Solarzelle 1 in einer perspektivischen Darstellung gezeigt, da sich aus dieser Figur nur der vorteilhafte Einsatz einer transparenten, gut leitfähigen Schicht ergeben soll. Die transparente, gut leitfähige Schicht 13 bzw. 14 befindet sich in dem Ausführungsbeispiel gemäß der Figur 3 sowohl auf der Rückseite 16 als auch auf der Vorderseite 15. Es ist aber auch möglich, auf einer oder beiden Oberflächenseiten auf die leitfähige Schicht 13 bzw. 14 zu verzichten. Beim Ausführungsbeispiel nach der Figur 3 befindet sich die transparente, gut leitfähige Schicht 13 bzw. 14 zwischen dem Halbleiterkörper und den Leitbahnsystemen 7 bzw. 11. Die Schicht 13 bzw. 14 besteht beispielsweise aus Zinnoxyd, das mit Antimon oder Fluor dotiert ist. Ein anderes geeignetes Material ist eine Indium-Zinnoxyd-Schicht. Diese Schichten werden beispielsweise durch Sputtern oder durch Elektronenstrahlverdampfung auf die Halbleiteroberflächen aufgebracht. Ein anderes geeignetes Verfahren ist die an sich bekannte Spray-Pyrolyse. Die transparente, leitfähige Schicht 13 bzw. 14 reduziert aufgrund ihrer guten Leitfähigkeit den Serienwiderstand der Solarzelle und wirkt zugleich als Antireflexschicht. Der Schichtwiderstand der Antireflexschicht ist vorzugsweise kleiner als 60 Ohm/square und ist bezüglich des maximalen Anteils des einfallenden Lichtes in der spektralen Verteilung eine λ/4-Schicht. Dies bedeutet, daß die Schicht größenordnungsmäßig ca. 70 nm dick ist. Die beiden Antireflexschichten 13 und 14 auf den beiden Oberflächenseiten der Solarzelle werden vorzugsweise der spektralen Verteilung der Wellenlängenanteile im jeweils einfallenden Licht so angepaßt, daß ein maximaler Wirkungsgrad erzielt wird. Dadurch ergibt sich eine optimale Anpassung der Solarzellen an den jeweiligen Verwendungszweck.

In der Figur 4 ist eine andere Variante für die Ausgestaltung der Antireflexschichten 13 bzw. 14 dargestellt. Hier befindet sich die Antireflexschicht nur zwischen den Fingerstrukturen 7 und 11 der Leitbahnsysteme auf Vorder- und Rückseite der Solarzelle. Dies erreicht man dadurch, daß die Antireflexschichten 13 und 14 mit Hilfe eines Maskenschrittes hergestellt werden oder aber dadurch, daß die Antireflexschichten zuerst hergestellt werden und dann die Leitbahnsysteme in einem Temperprozeß bis zur Halbleiteroberfläche durch die Antireflexschicht durchgetempert werden.

In Figur 5 ist eine weitere Variante dargestellt, bei der zunächst auf die beiden Oberflächenseiten 15 und 16 der Solarzelle die Leitbahnsysteme mit den Fingerstrukturen 7 bzw. 11 aufgebracht werden. Sodann werden die gesamten Oberflächenseiten der Solarzelle mit der Antireflexschicht 13 bzw. 14 bedeckt, die sich somit auch über die Leitbahnsysteme erstreckt.

In der Figur 6 sind mehrere Solarzellen 20 bis 23 dargestellt, die zu einem Solargenerator bzw. einem Teil eines Solargenerators zusammengeschaltet werden sollen. Hierzu ist erforderlich, daß der Rückseitenkontakt einer Solarzelle mit dem Vorderseitenkontakt einer benachbarten Solarzelle elektrisch leitend verbunden wird. Daraus resultiert, daß die Leitbahnsysteme auf der Rückseitenoberfläche bzw. auf der Vorderseite der Solarzelle derart aneinander angepasst werden müssen, daß eine leichte Verschaltung der Solarzellen untereinander unter Verwendung eingeführter Technologien ermöglicht wird. Die für die Verschaltung von benachbarten Solarzellen erforderlichen Verbinder 24 sollen dabei möglichst einfach ausgebildet und möglichst kurz sein. Diese Verbinder 24 bestehen beispielsweise aus Silber, Aluminium, Zinn, verzinntem Kupfer oder versilbertem Kupfer. Für den dargestellten Solargenerator sind zwei Zelltypen erforderlich. Die in einer Reihe hintereinander liegenden Solarzellen weisen Leitbahnsysteme auf, bei denen die Fingerstrukturen 7 auf der Vorderseite parallel zu den Fingerstrukturen 11 auf der Rückseite verlaufen. Wie aus der Figur 7 ersichtlich, ist dies beispielsweise bei den Zellen 22 und 23 der Fall. Da jedoch andererseits auch Solarzellenreihen untereinander verknüpft werden müssen, benötigt man für die Reihenenden Solarzellen, bei denen die Fingerstrukturen 7 auf der Vorderseite senkrecht zu den Fingerstrukturen 11 auf der Rückseite der Solarzelle verlaufen. Dies gilt gemäß Figur 7 für die Zellen 20 und 21. Die Anschlußstellen 8 bzw. 12 für die Verbinder 24 an die Leitbahnsysteme 5 und 6 auf der Vorder- und Rückseite 15 und 16 der Solarzelle liegen somit an einander gegenüberliegenden oder an einander benachbarten Seitenrändern der Solarzelle, wie sich dies aus den Figuren 6 und 7 ergibt. Die Verbinder 24 stellen jeweils den elektrischen Anschluß zwischen einer Anschlußstelle 12 auf der Rückseite der Solarzelle mit einer Anschlußstelle 8 auf der Vorderseite einer benachbarten Solarzelle her.

Bei einer weiteren, nicht im einzelnen dargestellten bevorzugten Ausführungsform weist das Leitbahnsystem auf der Zellenvorderseite eine Fingerstruktur auf, während auf der Zellenrückseite das Leitbahnsystem eine relativ engmaschige Gitterstruktur besitzt.

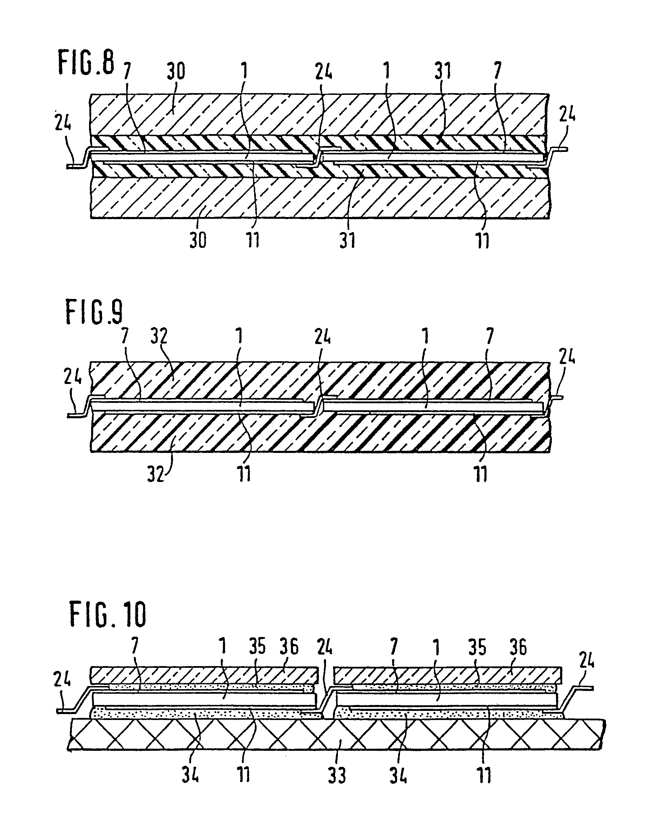

Die erfindungsgemäße Solarzelle läßt sich sowohl für den Einbau in orbitale als auch in terrestrische Solargeneratoren verwenden. Terrestrische Solargeneratoren haben in der Regel eine beidseitig transparente Kapselung bzw. Bedeckung der Zellen. So zeigt die Figur 8 einen terrestrischen Verbundglas-Generator, bei dem die Zellen 1 in einem symmetrischen Verbund zwischen zwei Glasscheiben 30 angeordnet sind. Der Verbund zwischen den Glasscheiben 30 und den Zellen 1 wird durch transparente elastische Materialien 31 hergestellt. Die Glasscheiben haben beispielsweise eine Dicke von 2 mm während das transparente elastische Material 31 beispielsweise aus zwei beidseitig auf die Solarzelle aufgelegten Folien aus PVB- bzw. EVA-Material mit einer Dicke von 0,7 mm besteht. Der so hergestellte Verbund wird dann evakuiert und bei 150 bis 170°C erwärmt, so daß das transparente elastische Material 31 sämtliche Hohlräume zwischen den beiden Glasscheiben 30 ausfüllt.

In Figur 9 ist ein weiterer terrestrischer Solargenerator dargestellt, bei dem das Einbettungsmaterial 32 für die Solarzellen 1 aus einem transparenten glasfaserverstärktem Harz besteht. Zur Herstellung dieses Generators, der eine Dicke von 1,5 bis 2 mm im fertigen Zustand aufweist, werden Glasfasermatten mit Harz getränkt und unter Einschluß der Zellen 1 zusammengefügt und danach ausgehärtet. Die Solarzellen 1 befinden sich somit bei diesem Solargenerator innerhalb einer einheitlichen Trägermasse 32 aus glasfaserverstärktem Harz.

In der Figur 10 ist noch ein orbitaler Solargenerator ausschnittsweise dargestellt, bei dem die Solarzellen 1 mit Hilfe eines transparenten Klebers 34 auf einem Träger 33 befestigt werden. Dieser Träger 33 besteht vorzugsweise aus einer transparenten Folie, einer glasfaserverstärkten Folie oder aus einem Material mit einer Honeycomb-Struktur. Die Honeycomb- bzw. Honigwabenstruktur besteht beispielsweise aus wabenförmig strukturierten Aluminiumfolien, die sich zwischen zwei transparenten Folien befinden. Die einzelnen Solarzellen 1 sind bei diesem orbitalen Generator auf der Vorderseite jeweils mit einem Deckglas 36 bedeckt, das vorzugsweise wiederum mit einem transparenten Kleber 35 an der Solarzellenvorderseite befestigt ist. Bei dem dargestellten orbitalen Solargenerator hat die Trägerfolie beispielsweise eine Dicke von 100 µm. Der transparente Kleber 34 ist 50 µm und der transparente Kleber 35 20 µm dick. Die Deckgläser haben vorzugsweise eine Dicke von 100 µm, während die Solarzellen für den orbitalen Anwendungsbereich vorzugsweise ca. 150 µm dick sind.

Anhand der erläuterten Ausführungsbeispiele ergibt sich, daß unter Verwendung der erfindungsgemäßen Solarzelle Solargeneratoren bei gleichen Systemkosten und dem Einsatz erprobter Technologien gebaut werden können, die eine erheblich höhere Leistung aufweisen als bisher eingesetzte Solargeneratoren. Anders ausgedrückt, reduziert sich bei Verwendung der erfindungsgemäßen Solarzellen das Leistungsgewicht eines Generators und das Preis-/Leistungsverhältnis verbessert sich.

## Patentansprüche

1. Solarzelle aus einem schiebenförmigen Halbleiterkörper (1), der einen pn-Übergang (4) enthält, wobei die beiden den pn-Übergang bildenden Zonen (2, 3) der Solarzelle auf gegenüberliegenden Oberflächenseiten (15, 16) des Halbleiterkörpers mit einem strukturierten, wesentliche Bereiche der Halbleiteroberfläche unbedeckt lassendem Leitbahnsystem (5, 6) kontaktiert sind, dadurch gekennzeichnet, daß der Halbleiterkörper (2) vom ersten Leitungstyp eine gleichmäßige Dotierung aufweist, daß an einer Oberflächenseite des Halbleiterkörpers eine dünne, gegenüber dem Grundkörper höher dotierte Zone (3) vom zweiten Leitungstyp vorgesehen ist, daß beide Oberflächenseiten des Halbleiterkörpers für die Bestrahlung vorgesehen sind und daß zur Reduzierung des Serienwiderstandes des Kontaktes an der schwächer dotierten Zone der Abstand zwischen benachbarten Strukturen des Kontaktes geringer ist als beim Kontakt an der höher dotierten Zone.

2. Solarzelle nach Anspruch 1, dadurch gekennzeichnet, daß die Oberflächenseite (15) des Halbleiterkörpers, in die die Zone vom zweiten Leitungstyp eingelassen ist, für die Lichteinstrahlung aus der Haupteinfallsrichtung (9) mit der höheren Intensität vorgesehen ist, während die unempfindlichere, gegenüberliegende Rückseite (16) des Halbleiterkörpers (1) für den Eintritt des Lichtes aus der Einfallsrichtung (10) mit geringerer Intensität vorgesehen ist.

3. Solarzelle nach Anspruch 1 oder 2, dadurch gekennzeichnet, daß die Solarzelle aus einkristallinem oder aus multikristallinem Silizium besteht, wobei ein multikristallines Material zur Erhöhung der effektiven Diffusionslänge der Minoritätsladungsträger und damit zur Erhöhung der Lichtempfindlichkeit einem Passivierungsverfahren unterworfen wird.

4. Solarzelle nach Anspruch 3, dadurch gekennzeichnet, daß zur Passivierung Wasserstoff verwendet wird.

5. Solarzelle nach einem der vorangehenden Ansprüche, dadurch gekennzeichnet, daß die Dotierung des Halbleitergrundkörpers (2) vom ersten Leitungstyp derart hoch gewählt ist und benachbarte Strukturen (11) des rückseitigen Leitbahnsystems (6) derart kleine Abstände voneinander aufweisen, daß der hierdurch bedingte Anteil des Serienwiderstandes der Zelle klein ist gegenüber dem Gesamtserienwiderstand.

6. Solarzelle nach einem der vorangehenden Ansprüche, dadurch gekennzeichnet, daß der Halbleitergrundkörper (1) der Solarzelle derart dünn gewählt ist, daß ein wesentlicher Anteil der rückseitig durch Lichteinstrahlung erzeugten Minoritätsladungsträger zum pn-Übergang (4) gelangt.

7. Solarzelle nach Anspruch 5, dadurch gekennzeichnet, daß der Halbleitergrundkörper einen spezifischen Widerstand von ca. 0,1 - 1 Ohmcm aufweist und die Oberflächenzone vom zweiten Leitungstyp einen Schichtwiderstand von ca. 30 - 200 Ohm/square besitzt.

8. Solarzelle nach Anspruch 6, dadurch gekennzeichnet, daß der Halbleiterkörper (1) dünner als 0,3 mm ist und daß die Oberflächenzone (3) vom zweiten Leitungstyp eine Schichtdicke von weniger als 0,5 µm aufweist.

9. Solarzelle nach Anspruch 5, dadurch gekennzeichnet, daß die Abstände zwischen den Strukturen (7) des Leitbahnsystems (5) beim Vorderseitenkontakt größer sind als die beim Rückseitenkontakt (6).

10. Solarzelle nach Anspruch 9, dadurch gekennzeichnet, daß die Leitbahnsysteme aus Fingerstrukturen (7, 11) bestehen, wobei die Strukturen auf der Zellenvorderseite parallel oder senkrecht zu denen auf der Rückseite verlaufen.

11. Solarzelle nach Anspruch 9, dadurch gekennzeichnet, daß das Leitbahnsystem auf der Zellenvorderseite aus einer Fingerstruktur und auf der Zellenrückseite aus einer Gitterstruktur besteht.

12. Solarzelle nach einem der vorangehenden Ansprüche, dadurch gekennzeichnet, daß zumindest Teilbereiche der Rückseite (16) des Halbleiterkörpers (1) mit einer transparenten, gut leitfähigen Schicht (14) bedeckt sind.

13. Solarzelle nach Anspruch 12, dadurch gekennzeichnet, daß die transparente, gut leitfähige Schicht (14) die Rückseitenoberfläche (16) des Halbleiterkörpers bedeckt und daß auf dieser Schicht das Leitbahnsystem (6) des Rückseitenkontaktes angeordnet ist.

14. Solarzelle nach Anspruch 12, dadurch gekennzeichnet, daß die freiliegenden Bereiche der Rückseitenoberfläche (16) zwischen den Strukturen (11) des Leitbahnsystems, das direkt auf die Halbleiteroberfläche (16) aufgebracht ist, mit der leitfähigen, transparenten Schicht (14) bedeckt sind.

15. Solarzelle nach Anspruch 12, dadurch gekennzeichnet, daß die mit dem strukturierten Leitbahnsystem versehene Rückseitenoberfläche der Solarzelle insgesamt mit der leitfähigen, transparenten Schicht (14) bedeckt ist.

16. Solarzelle nach einem der Ansprüche 12 bis 15, dadurch gekennzeichnet, daß die transparente, leitfähige Schicht (14) so gewählt ist, daß sie den Serienwiderstand der Solarzelle reduziert und zugleich als Antireflexschicht wirkt.

17. Solarzelle nach einem der Ansprüche 12 bis 16, dadurch gekennzeichnet, daß auch die Vorderseite (15) der Solarzelle mit einer Antireflexschicht (13) versehen ist, und daß die beiden Antireflexschichten (13, 14) auf der Vorder- und Rückseite der Solarzelle den in diese Flächen einfallenden Lichtverhältnissen bezüglich der spektralen Verteilung angepasst sind.

18. Solarzelle nach einem der vorangehenden Ansprüche, dadurch gekennzeichnet, daß das strukturierte Leitbahnsystem an der Rückseitenoberfläche der Solarzelle derart an das Leitbahnsystem an der Vorderseite angepasst ist, daß mehrere Zellen miteinander zu einem Solargenerator verschaltbar sind.

19. Solarzelle nach Anspruch 18, dadurch gekennzeichnet, daß die Leitbahnsysteme auf der Vorder- und Rückseite der Solarzelle derart ausgebildet sind, daß die Verbinder (24), die benachbarten Solarzellen (20 - 23) im Generator miteinander verschalten, möglichst kurz sind.

20. Solarzelle nach Anspruch 19, dadurch gekennzeichnet, daß die Anschlußstellen (8, 12) für die Verbinder (24) an die Leitbahnsysteme (5, 6) auf der Vorder- und Rückseite (15, 16) der Solarzelle (1) an einander gegenüberliegenden oder einander benachbarten Seiten der Solarzelle angeordnet sind.

21. Solarzelle nach einem der vorangehenden Ansprüche, gekennzeichnet durch ihre Verwendung für orbitale oder terrestrische Solargeneratoren.

22. Solarzelle nach einem der vorangehenden Ansprüche, gekennzeichnet durch ihre Verwendung in einem Generator, der eine beidseitige,

11

transparente Kapselung bzw. Bedeckung der Zellen aufweist.

23. Solarzelle nach einem der vorangehenden Ansprüche, gekennzeichnet durch ihre Verwendung in einem terrestrischen Verbundglas-Generator, bei dem die Zellen (1) in einem symmetrischen Verbund zwischen zwei Glasscheiben (30) angeordnet sind, wobei der Verbund zwischen den Glasscheiben (30) und den Zellen (1) durch transparente, elastische Materialien (31) hergestellt ist.

24. Solarzelle nach einem der vorangehenden Ansprüche, gekennzeichnet durch ihre Verwendung in einem terrestrischen Generator, bei dem die Zellen (1) in transparentes, glasfaserverstärktes Harz (32) eingebettet sind.

25. Solarzelle nach einem der vorangehenden Ansprüche, gekennzeichnet durch ihre Verwendung in einem Orbitalgenerator bei dem die Zellen (1) auf einem transparenten Träger (33) aus einer Folie, einer glasfaserverstärkten Folie oder aus einem Material mit Honeycomb-Struktur mittels eines lichtdurchlässigen Klebers (34) mit ihrer Rückseite befestigt sind, während die Vorderseiten der Zellen jeweils ein mit einem transparenten Kleber (35) befestigtes Deckglas (36) aufweisen.

## Claims

1. A solar cell consisting of a wafer-shaped semiconductor body (1) which contains a p-n junction (4), wherein the two regions (2, 3) of the solar cell forming the p-n junction are contacted, on opposite surfaces (15, 16) of the semiconductor body, by a structured conducting path system (5, 6) leaving substantial areas of the semiconductor surface uncovered, characterised in that the semiconductor body (2) of the first type of conductivity has a uniform doping, that a thin region (3) of the second type of conductivity, which is more highly doped than the basic body, is provided on one surface of the semiconductor body, that both surfaces of the semiconductor body, are adapted for irradiation, and that in order to reduce the series resistance of the contact at the more weakly doped region, the spacing between adjacent structures of the contact is less than in the contact at the more highly doped region.

2. A solar cell according to Claim 1, characterised in that the surface (15) of the semiconductor body into which the region of the second type of conductivity is let is provided for the incident light radiation from the main direction of incidence (9) having the higher intensity, while the less sensitive opposite back (16) of the semiconductor body (1) is provided for the entry of the light from the direction of incidence (10) having a lower intensity.

12

3. A solar cell according to Claim 1 or 2, characterised in that the solar cell consists of monocrystalline or of multicrystalline silicon, a multicrystalline material being subjected to a passivating process in order to increase the effective diffusion length of the minority carriers and hence to increase the light sensitivity.

4. A solar cell according to Claim 3, characterised in that hydrogen is used for the passivating.

5. A solar cell according to any one of the preceding Claims, characterised in that the doping of the semiconductor basic body (2) of the first type of conductivity is selected so high, and adjacent structures (11) of the rear conducting path system (6) have such short distances apart that the proportion of the series resistance of the cell due thereto is small in comparison with the total series resistance.

6. A solar cell according to any one of the preceding Claims, characterised in that the semiconductor basic body (1) of the solar cell is selected so thin that a substantial proportion of the minority carriers generated at the back by the incidence of light reaches the p-n junction (4).

7. A solar cell according to Claim 5, characterised in that the semiconductor basic body has a specific resistance of about 0.1 - 1 Ohmcm and the surface region of the second type of conductivity has a layer resistance of about 30 - 200 ohm/square.

8. A solar cell according to Claim 6, characterised in that the semiconductor body (1) is thinner than 0.3 mm, and that the surface region (3) of the second type of conductivity has a layer thickness of less than 0.5 $\mu$m.

9. A solar cell according to Claim 5, characterised in that the distances between the structures (7) of the conducting path system (5) in the front contact are greater than those in the back contact (6).

10. A solar cell according to Claim 9, characterised in that the conducting path systems consist of fingertype structures (7, 11), the structures on the front of the cell extending parallel or perpendicular to those on the back.

11. A solar cell according to Claim 9, characterised in that the conducting path system on the front of the cell consists of a finger-type structure and on the back of the cell of a gridded structure.

12. A solar cell according to any one of the preceding Claims, characterised in that at least component regions of the back (16) of the semiconductor body (1) are covered by a transparent layer (14) which is a good conductor.

13. A solar cell according to Claim 12, characterised in that the transparent layer (14) which is a good conductor covers the rear surface (16) of the semiconductor body and that the conducting path system (6) of the rear contact is disposed on this layer.

14. A solar cell according to Claim 12, characterised in that the exposed areas of the rear surface (16) between the structures (11) of the conducting path system which is applied directly to the semiconductor surface (16) are covered with the conductive transparent layer (14).

15. A solar cell according to Claim 12, characterised in that the rear surface of the solar cell, provided with the structured conducting path system, is covered as a whole by the conductive transparent layer (14).

16. A solar cell according to any one of Claims 12 to 15, characterised in that the transparent conductive layer (14) is selected so that it reduces the series resistance of the solar cell and at the same time acts as an anti-reflection layer.

17. A solar cell according to any one of Claims 12 to 16, characterised in that the front (15) of the solar cell is also provided with an anti-reflection layer (13), and that the two anti-reflection layers (13, 14) on the front and back of the solar cell are adapted to the light conditions incident in the areas with regard to the spectral distribution.

18. A solar cell according to any one of the preceding Claims, characterised in that the structured conducting path system on the rear surface of the solar cell is adapted to the conducting path system at the front in such a manner that a plurality of cells can be connected to one another to form a solar generator.

19. A solar cell according to Claim 18, characterised in that the conducting path systems on the front and back of the solar cell are constructed in such a manner that the connectors (24), which connect adjacent solar cells (20 - 23) to one another in the generator are as short as possible.

20. A solar cell according to Claim 19, characterised in that the places (8, 12) for connecting the connectors (24) to the conducting path systems (5, 6) on the front and back (15, 16) of the solar cell (1) are arranged at sides of the solar cell situated opposite one another or adjacent to one another.

21. A solar cell according to any one of the preceding Claims, characterised by its use for orbital or terrestrial solar generators.

22. A solar cell according to any one of the preceding Claims, characterised by its use in a generator which comprises a transparent encapsulation or covering of the cells at both sides.

23. A solar cell according to any one of the preceding Claims, characterised by its use in a terrestrial laminated-glass generator wherein the cells (1) are arranged in a symmetrical composite structure between two panes of glass (30), the bond between the panes of glass (30) and the cells (1) being established by transparent, resilient materials (31).

24. A solar cell according to any one of the preceding Claims, characterised by its use in a terrestrial generator wherein the cells (1) are embedded in transparent, glass-fibre-reinforced resin (32).

25. A solar cell according to any one of the preceding Claims, characterised by its use in an orbital generator wherein the cells (1) are secured by their back to a transparent support (33) of a sheet, of a glass-fibre-reinforced sheet or of a material with a honeycomb structure, by means of a translucent adhesive (34), while the fronts of the cells each comprise a glass cover (36) secured by a transparent adhesive (35).

**Revendications**

1. Cellule solaire constituée d'un corps semiconducteur (1) en forme de plaquette qui contient une jonction pn (4), cellule dans laquelle les deux zones (2, 3) de la cellule solaire qui forment la jonction pn sont mises en contact, sur les faces opposées (15, 16) du corps semiconducteur, avec un système structuré de rubans conducteurs (5, 6) qui laissent découvertes des régions essentielles de la surface du semiconducteur, caractérisée en ce que le corps semiconducteur (2) présente un dopage régulier d'un premier type de conduction; en ce que sur une face du corps semiconducteur est prévue une zone mince (3), plus fortement dopée que le corps de base, du second type de conduction; en ce que les deux faces du corps semiconducteur sont prévues pour l'exposition à la lumière; et en ce que, pour réduire la résistance de série du contact sur la zone plus faiblement dopée, la distance entre les structures, voisines, du contact est plus faible que dans le cas du contact sur la zone plus fortement dopée.

2. Cellule solaire selon la revendication 1, caractérisée en ce que la face (15) du corps semiconducteur dans laquelle se trouve la zone du second type de conduction est prévue pour être exposée à la lumière dans la direction principale d'incidence (9) présentant l'intensité la plus élevée, tandis que la face arrière opposée (16), moins sensible, du corps semiconducteur (1) est prévue pour l'entrée de la lumière dans la direction d'incidence (10) présentant l'intensité la plus faible.

3. Cellule solaire selon la revendication 1 ou 2, caractérisée en ce que la cellule solaire est constituée d'un silicium monocristallin ou multicristallin, étant précisé que, pour accroître la longueur de diffusion efficace des porteurs de charge minoritaires, et donc pour accroître la sensibilité à la lumière, un matériau multicristallin est soumis à un procédé de passivation.

4. Cellule solaire selon la revendication 3, caractérisée en ce que pour la passivation on emploie de l'hydrogène.

5. Cellule solaire selon l'une des revendications précédentes, caractérisée en ce que le dopage du corps de base semiconducteur (2) par un premier type de conduction est choisi suffisamment élevé, et en ce que des structures voisines (11) du système de rubans conducteurs (6) de la face arrière présentent entre elles des distances suffisamment faibles pour que la proportion qui en résulte de la résistance de série de la cellule soit faible par rapport à la résistance de série totale.

6. Cellule solaire selon l'une des revendications précédentes, caractérisée en ce que le corps de base semiconducteur (1) de la cellule solaire est choisi suffisamment mince pour qu'une proportion sensible des porteurs de charge minoritaires créés sur la face arrière par l'exposition à la lumière parvienne à la jonction pn (4).

7. Cellule solaire selon la revendication 5, caractérisée en ce que le corps de base semiconducteur présente une résistance spécifique d'environ 0,1 - 1 ohm/cm et en ce que la zone de surface du second type de conduction présente une résistance de couche d'environ 30 - 200 ohm/square (4,6 - 31 ohm/cm$^2$).

8. Cellule solaire selon la revendication 6, caractérisé en ce que le corps semiconducteur (1) est plus mince que 0,3 mm et en ce que la zone de surface (3) du second type de conduction présente une épaisseur de couche inférieure à 0,5 μm.

9. Cellule solaire selon la revendication 5, caractérisée en ce que les distances entre les structures (7) des systèmes de rubans conducteurs (5) sont plus grandes dans le cas du contact entre faces avant que dans le cas du contact entre faces arrière (6).

10. Cellule solaire selon la revendication 9, caractérisée en ce que les systèmes de rubans conducteurs sont constitués de structures en doigts (7, 11), étant précisé que les structures prévues sur la face avant de la cellule sont dirigées parallèlement ou perpendiculairement à celles prévues sur la face arrière.

11. Cellule solaire selon la revendication 9, caractérisée en ce que le système de rubans conducteurs prévu sur la face avant de la cellule est constitué d'une structure en doigts et que celui prévu sur la face arrière de la cellule est constitué d'une structure de grille.

12. Cellule solaire selon l'une des revendications précédentes, caractérisée en ce qu'au moins des régions partielles de la face arrière (16) du corps semiconducteur (1) sont recouvertes d'une couche transparente, bonne conductrice (14).

13. Cellule solaire selon la revendication 12, caractérisée en ce que la couche transparente, bonne conductrice (14) recouvre la surface de la face arrière (16) du corps semiconducteur et en ce que c'est sur cette couche qu'est disposé le système de rubans conducteurs (6) de contact de la face arrière.

14. Cellule solaire selon la revendication 12, caractérisée en ce que les régions libres de la face arrière (16) situées entre les structures (11) du système de rubans conducteurs (16) qui est directement rapporté sur la surface (16) du corps semiconducteur, sont recouvertes de la couche conductrice transparente (14).

15. Cellule solaire selon la revendication 12, caractérisée en ce que la face arrière, munie du système structuré de rubans conducteurs, de la cellule solaire est totalement recouverte de la couche conductrice transparente (14).

16. Cellule solaire selon l'une des revendications 12 à 15, caractérisée en ce que l'on choisit la couche transparente conductrice (14) de façon qu'elle réduise la résistance de série de la cellule solaire et agisse simultanément comme couche antiréfléchissante.

17. Cellule solaire selon l'une des revendications 12 à 16, caractérisée en ce que la face avant (16) de la cellule solaire est également munie d'une couche antiréfléchissante (13); et en ce que les deux couches antiréfléchissantes (13, 14) prévues sur la face avant et sur la face arrière de la cellule solaire sont adaptées aux conditions de la lumière incidente sur ses surfaces en ce qui concerne la répartition spectrale.

18. Cellule solaire selon l'une des revendications précédentes, caractérisée en ce que le système structuré de rubans conducteurs prévue sur la face arrière de la cellule solaire est adapté au système de rubans conducteurs prévu sur la face avant de façon telle que plusieurs cellules puissent être connectées ensemble pour donner un générateur solaire.

19. Cellule solaire selon la revendication 18, caractérisée en ce que les systèmes de rubans conducteurs prévus sur la face avant et sur la face arrière de la cellule solaire sont conçus de façon telle que les connecteurs (24), qui connectent ensemble les cellules solaires voisines (20 - 23) dans le générateur, soient les plus courts possible.

20. Cellule solaire selon la revendication 19, caractérisée en ce que les positions de raccordements (8, 12) pour les connecteurs (24) sur les sytèmes de rubans conducteurs (5, 6) prévus sur la face avant et sur la face arrière (15, 16) de la cellule solaire sont disposés sur les côtés, opposés l'un à l'autre, ou voisins l'un de l'autre, de la cellule solaire.

21. Cellule solaire selon l'une des revendications précédentes caractérisée par son emploi pour des générateurs solaires orbitaux ou terrestres.

22. Cellule solaire selon l'une des revendications précédentes, caractérisée par son emploi dans un générateur qui présente des deux côtés un encapsulage ou un recouvrement transparent des cellules.

23. Cellule solaire selon l'une des revendications précédentes, caractérisée par son emploi dans un générateur terrestre à verre de liaison, dans le cas duquel les cellules (1) sont disposées, en une liaison symétrique, entre deux plaques de verre (30), étant précisé que la liaison entre les plaques de verre (30) et les cellules (1) est réalisée au moyen de matériaux transparents, élastiques (31).

24. Cellule solaire selon l'une des revendications précédentes, caractérisée par son emploi dans un générateur terrestre dans le cas duquel les cellules (1) sont enrobées dans une résine transparente, armée de fibres de verre (32).

25. Cellule solaire selon l'une des revendications précédentes, caractérisée par son emploi dans un générateur orbital dans le cas duquel les cellules sont fixées, par leur face arrière, sur un support transparent (33) constitué d'une feuille, d'une feuille armée de fibres de verre ou d'un matériau à structure en nid d'abeilles, au moyen d'une colle translucide (34), tandis que les faces avant des cellules présentent respectivement un verre de reouvrement (36) fixé avec une colle transparente (35).

FIG.1

FIG.2

FIG.3

FIG.4

FIG.5

3

FIG. 6

FIG.7

5

FIG.8

FIG.9

FIG.10